(19) Europäisches Patentamt
European Patent Office
Office européen des brevets

(11) **EP 3 789 778 B1**

(12) **EUROPEAN PATENT SPECIFICATION**

(45) Date of publication and mention
of the grant of the patent:
**06.12.2023   Bulletin 2023/49**

(21) Application number: **19195852.9**

(22) Date of filing: **06.09.2019**

(51) International Patent Classification (IPC):
**G01R 31/28** (2006.01)

(52) Cooperative Patent Classification (CPC):
**H04B 17/0085; G01R 31/2822; H04L 27/2602;**
G01R 29/0892; H04L 27/2626

(54) **METHOD AND DEVICE FOR GENERATING TEST SIGNALS AT DIFFERENT CARRIER FREQUENCIES**

VERFAHREN UND VORRICHTUNG ZUR ERZEUGUNG VON TESTSIGNALEN BEI VERSCHIEDENEN TRÄGERFREQUENZEN

PROCÉDÉ ET DISPOSITIF POUR GÉNÉRER DES SIGNAUX DE TEST À DIFFÉRENTES FRÉQUENCES PORTEUSES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.03.2021   Bulletin 2021/10**

(73) Proprietor: **Rohde & Schwarz GmbH & Co. KG 81671 München (DE)**

(72) Inventors:
• **Winklhofer, Max**
**80809 München (DE)**
• **Lorenzen, Rolf**
**82024 Taufkirchen (DE)**
• **Krakowski, Claudiu**
**85586 Poing (DE)**
• **Hank, Daniel**
**81671 München (DE)**

(74) Representative: **Rupp, Christian et al**
**Mitscherlich PartmbB**
**Patent- und Rechtsanwälte**
**Karlstraße 7**
**80333 München (DE)**

(56) References cited:
**US-A1- 2013 226 499     US-A1- 2014 160 955**
**US-A1- 2014 233 623     US-A1- 2014 242 919**

• **Anritsu Anritsu: "IQproducer(TM) Operation Manual Second Edition", , 25 February 2019 (2019-02-25), XP055673062, Retrieved from the Internet:**
**URL:https://dl.cdn-anritsu.com/en-au/test-measurement/files/Manuals/Operation-Manual /MG3710A/MX370113A_MX269913A_opm_e_2_0 .pdf**
• **Keysight Keysight: "Keysight Technologies 5G Waveform Generation & Analysis Testbed, Reference Solution Solution Brochure 02 | Keysight | 5G Waveform Generation & Analysis Testbed, Reference Solution -Solution Brochure", , 28 August 2015 (2015-08-28), XP055673440, Retrieved from the Internet:**
**URL:https://tekmarkgroup.com/eshop/image/c atalog/Application/K5G/5992-1030EN_5G_Wave form_Generation.pdf**

EP 3 789 778 B1

## Description

The invention relates to test signal generation at different carrier frequencies, especially for generating Fifth Generation New Radio (5G-NR) signals that can be used at different carrier frequencies.

Generally, in order to perform radio frequency tests, test signals are generated externally for calibrating and verifying the operation bands of a device under test. The operation bands varies over a range of frequency bands based on the requirements of particular communication standards. Normally, test files, which are designated to particular test types, are utilized in order to generate the test signals for production. These test files are generated with predefined test criteria, for instance the operating bands and/or frequencies at which the device under test to be evaluated.

For example, the document US 10,191,098 B2 shows test signal generation method for operating an electronic measurement device, wherein the generated test signal is at least adjustable in its signal frequency. An arbitrary waveform generator generates the test signals by utilizing test files that are stored in storage means of the electronic measurement device.

The document US 2014/0233623 A1 discloses a mobile communication terminal test device for generating a signal with amplitude-frequency characteristics or phase-frequency characteristics that are changed over time.

The document US 2014/0242919 A1 discloses a test signal generation apparatus in order to simplify a parameter setting process required to generate a test signal based on an LTE-Advanced system.

The document Anritsu Anritsu: "IQproducer(TM) Operation Manual Second Edition", 25 February 2019, XP055673062, discloses basic operations and functions of the 5G NR TDD sub-6GHz IQproducer, especially used for generating waveform patterns conforming to the 3GPP 5G NR specifications.

However, in the case of 5G-NR standards, the signals are dependent on the used carrier frequency. Consequently, a different test file is required for each carrier frequency to perform a designated test, which results in a large number of test files to be stored in the test system beforehand. One possible alternative is to generate the test signal by means of an online generator. However, the development of such an online generator requires not only network resources but also time and manpower.

Accordingly, the object of the invention is to provide a method, a device and computer program for generating test signals in a simplified manner without consuming additional resources, especially to address the requirements in 5G-NR.

The object is solved by the features of the first independent claim for the method and by the features of the second independent claim for the device. The dependent claims contain further developments and the computer program.

According to a first aspect of the invention, a method for generating test signals at different carrier frequencies is provided. The method comprises the step of selecting a test file from a list of test files comprising pre-existing test frequencies corresponding to a range of predefined tests to be conducted. The method further comprises the step of modifying the test file in order to request a frequency input from a user and to specify the frequency input as a test frequency. Furthermore, the method comprises the step of generating a set of instructions in the test file in order to calculate a phase shift for a subcarrier spacing with respect to the frequency input. Moreover, the method comprises the step of generating a phase pattern of modulation symbols for the subcarrier spacing corresponding to the frequency input thereby generating a test signal at the test frequency.

Therefore, instead of generating a different test file for every frequency, one test file is advantageously used for all frequencies. As a result, the file handling and file generation are more convenient for the user with a minimum required storage space, thereby facilitating a simplified technique in order to generate 5G-NR test signals at different carrier frequencies. Furthermore, in contrast to Long Term Evolution (LTE) subcarrier spacing and symbol length, the NR supports multiple different types of subcarrier spacing. The minimum subcarrier spacing is 15 KHz (SCS 15), which is the same as LTE. However, the successive subcarrier spacing (SCS 30, SCS 60 and so on) are derived by scaling up in the power of 2. The corresponding modulation symbols are generally complex values with distinct amplitude and phase requirements. Hence, depending on the frequency the phase of the modulation symbols changes.

According to a first preferred implementation form of said first aspect of the invention, the test file format is a localization resource format, preferably an Application Resource Bundle (ARB) format. Advantageously, the test signal is generated in a simplified manner. Furthermore, the ARB file format is simple, extensible and directly usable, thereby facilitating the user a larger margin for modification of the standard file format in order to request the frequency input and correspondingly specifying the input frequency as the test frequency.

According to a second preferred implementation form of said first aspect of the invention, the method further comprises the step of generating phase patterns of modulation symbols for each subcarrier spacing corresponding to the frequency input based on the information regarding the calculation of the phase shift provided in the test file beforehand. For instance, the information may define how to calculate the phase shift for the inputted frequency of the user and the components are stored separately. Additionally or alternatively, the standard 5G-NR waveforms are calculated beforehand and the respective components are stored separately.

According to a further preferred implementation form of said first aspect of the invention, the method further comprises the step of implementing the respective phase pattern of modulation symbols on each subcarrier spacing. Advantageously, the phase patterns of modulation symbols for each subcarrier spacing are generated in real time with respect to the frequency input of the user.

According to a further preferred implementation form of said first aspect of the invention, the method further comprises the step of applying a filtration after the respective phase pattern of modulation symbols for each subcarrier spacing has been implemented. In this context, the filtration is based on impulse response filtration, preferably finite impulse response filtration. Advantageously, the signal generation is compatible with multi-rate applications that may require decimation, interpolation or both.

According to a further preferred implementation form of said first aspect of the invention, the method further comprises the step of generating the phase patterns of modulation symbols in accordance with Third Generation Partnership Project (3GPP) standards. Advantageously, the test signal criteria, for instance the modulation and up-conversion scheme, are defined in conformity with the radio performance and protocol aspects of 3GPP (3GPP RAN4).

According to a second aspect of the invention, a device for generating test signals at different carrier frequencies is provided. The device comprises a file input for receiving a list of test files comprising pre-existing test frequencies corresponding to a range of predefined tests to be conducted. In addition, the device comprises a control input for receiving control commands in order to select a test file from the list of test files. Furthermore, the device comprises a user input for receiving a frequency input from a user. Moreover, the device comprises a processor adapted to modify the test file in order to request the frequency input from the user and to specify the frequency input as a test frequency. The processor is further adapted to generate a set of instructions in the test file in order to calculate a phase shift for a subcarrier spacing with respect to the frequency input. The processor is moreover adapted to generate a phase pattern of modulation symbols for the subcarrier spacing corresponding to the frequency input thereby generating a test signal at the test frequency.

Therefore, instead of generating a different test file for every frequency, one test file is advantageously used for all frequencies. As a result, the file handling and file generation are more convenient for the user with a minimum required storage space, thereby generating 5G-NR test signals at different carrier frequencies in a simplified manner.

According to a first preferred implementation form of said second aspect of the invention, the test file format is a localization resource format, preferably an Application Resource Bundle (ARB) format. Advantageously, the test signal is generated in a simplified manner. Furthermore, the ARB file format is simple, extensible and directly usable, thereby facilitating the user a larger margin for modification of the standard file format in order to request the frequency input and correspondingly specifying the input frequency as the test frequency.

According to a second preferred implementation form of said second aspect of the invention, the processor is further adapted to generate phase patterns of modulation symbols for each subcarrier spacing corresponding to the frequency input based on the information regarding the calculation of the phase shift provided in the test file beforehand. In this context, the phase patterns of modulation symbols are different for each subcarrier spacing. For instance, the information may define how to calculate the phase shift for the inputted frequency of the user and the components are stored separately. Additionally or alternatively, the standard 5G-NR waveforms are calculated beforehand and the respective components are stored separately.

According to a further preferred implementation form of said second aspect of the invention, the processor is further adapted to implement the respective phase pattern of modulation symbols on each subcarrier spacing. Advantageously, the phase patterns of modulation symbols for each subcarrier spacing are generated in real time with respect to the frequency input of the user.

According to a further preferred implementation form of said second aspect of the invention, the processor is further adapted to apply a filtration after the respective phase pattern of modulation symbols for each subcarrier spacing has been implemented. In this context, the filtration is based on impulse response filtration, preferably finite impulse response filtration. Advantageously, the signal generation is compatible with multi-rate applications that may require decimation, interpolation or both.

According to a further preferred implementation form of said second aspect of the invention, the phase patterns of modulation symbols are generated in accordance with Third Generation Partnership Project (3GPP) standards. Advantageously, the test signal criteria, for instance the modulation and up-conversion scheme, are defined in conformity with the radio performance and protocol aspects of 3GPP (3GPP RAN4).

Exemplary embodiments of the invention are now further explained with respect to the drawings by way of example only, and not for limitation. In the drawings:

Fig. 1 shows an exemplary embodiment of the method according to the first aspect of the invention;

Fig. 2 shows an exemplary embodiment of the device according to the second aspect of the invention;

Fig. 3 shows a test signal generating operation of the processor in block diagram by way of an example;

Fig. 4a    shows time domain representation of the test signal magnitude; and

Fig. 4b    shows time domain representation of the test signal phase.

Reference will now be made in detail to the embodiments of the present invention, examples of which are illustrated in the accompanying drawings. However, the following embodiments of the present invention may be variously modified and the range of the present invention is not limited by the following embodiments.

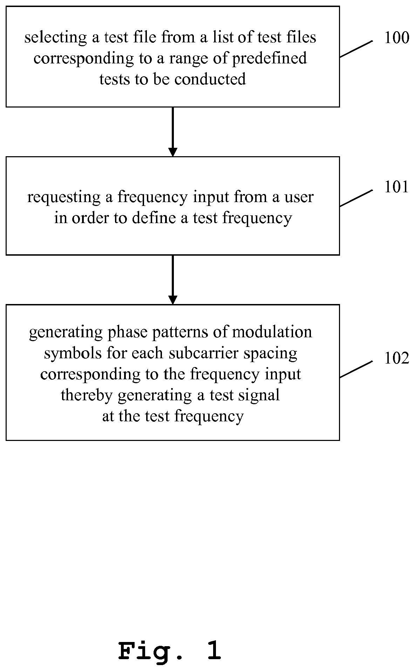

In Fig. 1, an exemplary embodiment of the method according to the first aspect of the invention is illustrated. In a first step 100, a test file is selected from a list of test files corresponding to a range of predefined tests to be conducted. In a second step 101, a frequency input is requested from a user in order to define a test frequency. In a third step 102, phase patterns of modulation symbols are generated for each subcarrier spacing corresponding to the frequency input thereby generating a test signal at the test frequency. In this context, the test file format is a localization resource format, preferably an Application Resource Bundle (ARB) format.

In addition to this, the method further comprises the step of calculating phase patterns of modulation symbols for each subcarrier spacing corresponding to the frequency input based on the information provided in the test file beforehand.

Moreover, the method further comprises the step of implementing the respective phase pattern of modulation symbols on each subcarrier spacing.

It might be further advantageous if the method further comprises the step of applying a filtration after the respective phase pattern of modulation symbols for each subcarrier spacing has been implemented.

Additionally, the method further comprises the step of the method further comprises the step of generating the phase patterns of modulation symbols in accordance with Third Generation Partnership Project (3GPP) standards.

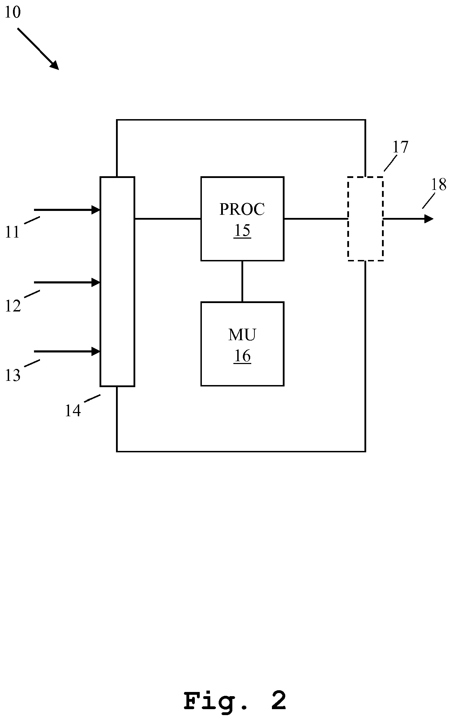

In Fig. 2, an exemplary embodiment of the device 10 according to the first aspect of the invention is illustrated. The device comprises a file input 11, a control input 12 and a user input 13, preferably connected to an input module 14. The input module 14 can be any form of an interface, adapted to receive inputs in conductive and/or wireless manner. The input module 14 is connected to a processor 15, which is further connected to a memory unit 16. It is to be noted that the input module 14 is not necessarily connected directly to the processor 15; a wireless connection by means of wireless local area network (WLAN) is also possible.

The file input 11, the control input 12 and the user input 13 may be generated through a user interface, preferably a graphical user interface including menu based interface and direct manipulation interface so as to allow the user to configure the test inputs. Additionally or alternatively, the inputs can be loaded to the input module 14 and thereby to the processor 15 by means of predefined texts, for instance via Extensible Markup Language (XML) files, binary files and the like.

The processor 15 receives a list of test files, for instance ARB files through the file input 11 and stores in the memory unit 16. The memory unit 16 may further store programs required for signal processing and controlling of the processor 15 and temporarily store input and output information. The user may provide control commands via the control input 12 for selecting a test file from the list of test files stored in the memory unit 16. Since each test file corresponds to a specific test, only one test file is selected and is utilized at a given test criterion. The processor 15 also receives a frequency input from the user via the user input 13 in order to identify the test frequency and thereby generates the test signal 18 at the test frequency.

In this context, the processor 15 may also be referred to as microcontrollers, microprocessors, microcomputers, etc. The processor 15 may further be configured in hardware, firmware, software, or their combination. Furthermore, the memory unit 16 may be implemented into a flash memory type storage, a hard disc type storage, a card type memory, a Random Access Memory (RAM), a Read Only Memory (ROM) and the like.

The device 10 may optionally comprise an output module 17, connected to the processor 15, through which the generated test signal 18 is fed to a device under test (not shown). Alternatively, the processor 15 outputs the generated test signal 18 to the device under test directly, for instance by means of RF cables. If the output module 17 is present, it performs additional signal mixing and filtering operations as required. In this context, the output module 17 may also be referred to as RF front end, RF radio head and the like. Therefore, it is possible to transmit the test signal 18 to the device under test via RF cables and/or antennas, either connected to the output module 17 or to the processor 15 directly.

The device 10 may further comprise a display connected to the processor 15, in order to display a selective test result and the user defined test criteria, for instance the test frequency, subcarrier spacing and so on. The output to be displayed on the display can be manipulated through a set of user instructions received, for instance via the user input 13 directly, preferably in real-time. Alternatively, the user instructions can be loaded to the processor 15 from the memory unit 16 by means of control commands through the control input 12, where the instructions are stored in the memory unit 16 previously.

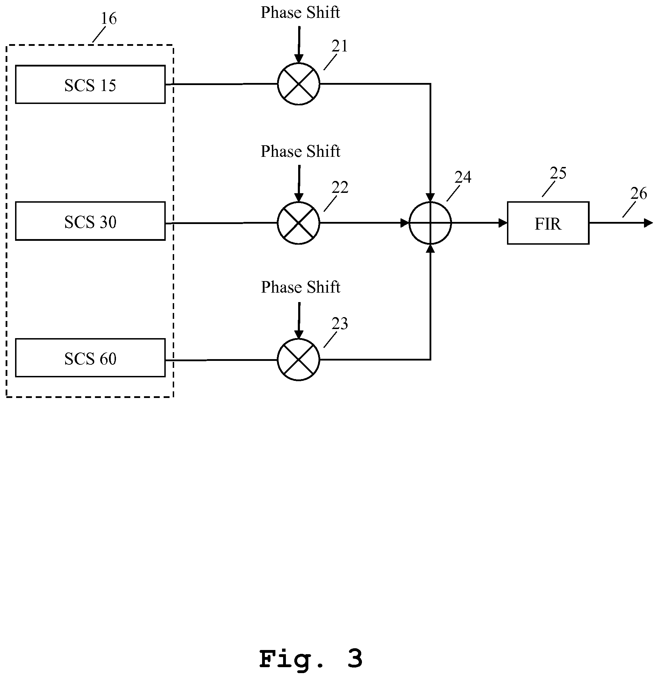

In Fig. 3, a test signal generating operation of the processor 15 is illustrated in block diagram by way of an example. In 5G-NR the transmission bandwidth is generally smaller than the overall channel bandwidth and comprises different bandwidth parts with variable lengths. Each bandwidth part has its own signal components and can use different subcarrier spacing. Hence, a typical multicarrier signal comprises different subcarrier spacing that includes modulation symbols with different phase patterns, which are susceptible to operating frequency. As a result, the phase of the modulation symbols changes depending on the frequency.

It is advantageous to store the waveform components, for instance the modulation symbols and their phase patterns separately from pre-calculated NR waveforms. A test file can therefore be predefined with additional information regarding the calculation of respective phase shifts corresponding to the input frequency of the user. Especially, standard ARB file format facilitates user modification with ease so that the file format can be changed if required.

For example, the signal components can be stacked in the memory unit 16 and the processor calculates a phase shift for each subcarrier spacing with respect to the input frequency. Since the phase patterns of the modulation symbols for each subcarrier spacing are different, the processor 15 applies a different phase shift, which is calculated based on the information provided in the ARB file, to each subcarrier spacing with respect to the input frequency. For instance, the processor 15 applies a phase shift 21 to the SCS 15, a phase shift 22 to the SCS 30, a phase shift 23 to the SCS 60 and so on. The shifted versions of the signals are summed up 24 and then filtered out 25, thereby generating the test signal 26 at the input frequency.

The SCS 15, SCS 30 and SCS 60 are illustrated herein only for demonstrating the signal processing operation of the processor 15 and not for limiting the scope of the invention to any selective components. In addition, the FIR filter 25 can be designed based on any common design method such as window design method, frequency-sampling method, weighted least squares design method etc. The foregoing design methods are not discussed herein in details in order to avoid unnecessarily obscuring the invention.

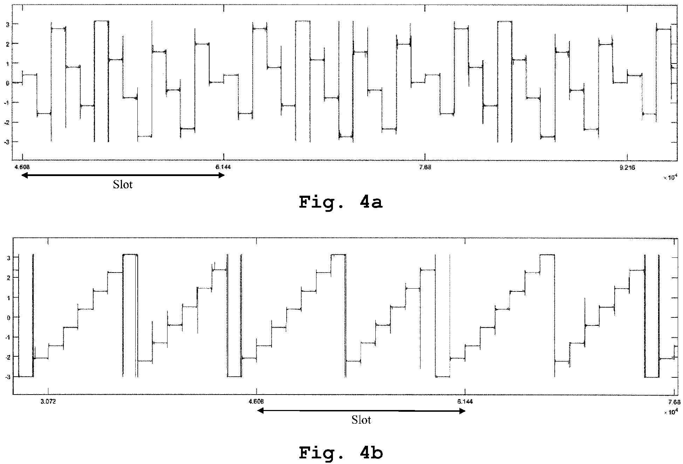

Fig 4a and Fig 4b respectively illustrate the magnitude and phase representation of the test signal. The test signal is segmented over multiple slot spans, where each slot typically comprises 14 modulation symbols, especially Orthogonal Frequency Division Multiplexing (OFDM) symbols. Each symbol consists of a complex number, especially complex exponential that defines a mean phase of that OFDM symbol over one symbol duration (herein illustrated in radians). A slot duration can be defined as:

$$T_{slot} = 15360 T_s$$

Where, $T_s$ is the basic timing unit.

For instance, SCS 30 comprises one subcarrier with a spacing of 30 KHz, distributed over one radio frame with a duration of 10 ms. The radio frame comprises 10 subframes, where each subframe of 1 ms generally occupied by two slots, each comprising a duration of 0.5 ms.

The embodiments of the present invention can be implemented by hardware, software, or any combination thereof. Various embodiments of the present invention may be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, or the like.

While various embodiments of the present invention have been described above, it should be understood that they have been presented by way of example only, and not limitation. Numerous changes to the disclosed embodiments can be made in accordance with the disclosure herein without departing from the scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A method for generating test signals at different carrier frequencies comprises the steps of:

   selecting a test file from a list of test files comprising pre-existing test frequencies corresponding to a range of predefined tests to be conducted,
   modifying the test file in order to request a frequency input from a user and to specify the frequency input as a test frequency,
   generating a set of instructions in the test file in order to calculate a phase shift for a subcarrier spacing with respect to the frequency input, and
   generating a phase pattern of modulation symbols for the subcarrier spacing corresponding to the frequency input thereby generating a test signal at the test frequency.

2. The method according to claim 1, wherein the test file format is a localization resource format, preferably an Application Resource Bundle (ARB) format.

**3.** The method according to claim 1 or 2, wherein the method further comprises the step of generating phase patterns of modulation symbols for each subcarrier spacing corresponding to the frequency input based on the information regarding the calculation of the phase shift provided in the test file beforehand.

**4.** The method according to claim 3, wherein the method further comprises the step of implementing the respective phase pattern of modulation symbols on each subcarrier spacing.

**5.** The method according to claim 4, wherein the method further comprises the step of applying a filtration after the respective phase pattern of modulation symbols for each subcarrier spacing has been implemented.

**6.** The method according to claim 1, wherein the method further comprises the step of generating the phase patterns of modulation symbols in accordance with Third Generation Partnership Project (3GPP) standards.

**7.** A device (10) for generating test signals at different carrier frequencies comprising:

> a file input (11) for receiving a list of test files comprising pre-existing test frequencies corresponding to a range of predefined tests to be conducted,
> a control input (12) for receiving control commands in order to select a test file from the list of test files,
> a user input (13) for receiving a frequency input from a user, and
> a processor (15) adapted to modify the test file in order to request the frequency input from the user and to specify the frequency input as a test frequency,
> wherein the processor (15) is further adapted to generate a set of instructions in the test file in order to calculate a phase shift for a subcarrier spacing with respect to the frequency input, and
> wherein the processor (15) is further adapted to generate a phase pattern of modulation symbols for the subcarrier spacing corresponding to the frequency input thereby generating a test signal (18) at the test frequency.

**8.** The device according to claim 7, wherein the test file format is a localization resource format, preferably an Application Resource Bundle (ARB) format.

**9.** The device according to claim 7 or 8, wherein the processor (15) is further adapted to generate phase patterns of modulation symbols for each subcarrier spacing corresponding to the frequency input based on the information regarding the calculation of the phase shift provided in the test file beforehand.

**10.** The device according to claim 9, wherein the phase patterns of modulation symbols are different for each subcarrier spacing.

**11.** The device according to claim 9, wherein the processor (15) is further adapted to implement the respective phase pattern of modulation symbols on each subcarrier spacing.

**12.** The device according to claim 11, wherein the processor (15) is further adapted to apply a filtration (25) after the respective phase pattern of modulation symbols for each subcarrier spacing has been implemented.

**13.** The device according to claim 12, wherein the filtration (25) is based on impulse response filtration, preferably finite impulse response filtration.

**14.** The device according to claim 7, wherein the phase patterns of modulation symbols are generated in accordance with Third Generation Partnership Project (3GPP) standards.

**15.** Computer program with program code means in order to proceed with all steps of any of claims 1 to 6 if the computer program runs on a computer or a digital signal processor.

**Patentansprüche**

**1.** Verfahren zum Erzeugen von Testsignalen bei verschiedenen Trägerfrequenzen, das die Schritte umfasst:

> Auswählen einer Testdatei aus einer Liste von Testdateien, umfassend bereits vorhandene Testfrequenzen, die einem Bereich von vordefinierten Tests entsprechen, die durchgeführt werden sollen,
> Modifizieren der Testdatei, um eine Frequenzeingabe von einem Benutzer anzufordern und um die Frequenzeingabe als eine Testfrequenz anzugeben,
> Erzeugen eines Satzes von Anweisungen in der Testdatei, um eine Phasenverschiebung für einen Hilfsträgerabstand in Bezug auf die Frequenzeingabe zu berechnen, und
> Erzeugen eines Phasenmusters von Modulationssymbolen für den Hilfsträgerabstand, der der Frequenzeingabe entspricht, wodurch ein Testsignal bei der Testfrequenz erzeugt wird.

2. Verfahren nach Anspruch 1,
wobei das Testdateiformat ein Lokalisierungsressourcenformat, vorzugsweise ein Anwendungsressourcenbündel-Format (ARB-Format) ist.

3. Verfahren nach Anspruch 1 oder 2,
wobei das Verfahren ferner den Schritt des Erzeugens von Phasenmustern von Modulationssymbolen für jeden Hilfsträgerabstand, der der Frequenzeingabe entspricht, basierend auf den Informationen bezüglich der Berechnung der Phasenverschiebung umfasst, die zuvor in der Testdatei bereitgestellt werden.

4. Verfahren nach Anspruch 3,
wobei das Verfahren ferner den Schritt des Implementierens des jeweiligen Phasenmusters von Modulationssymbolen an jedem Hilfsträgerabstand umfasst.

5. Verfahren nach Anspruch 4,
wobei das Verfahren ferner den Schritt eines Anwendens einer Filterung umfasst, nachdem das jeweilige Phasenmuster von Modulationssymbolen für jeden Hilfsträgerabstand implementiert wurde.

6. Verfahren nach Anspruch 1,
wobei das Verfahren ferner den Schritt des Erzeugens der Phasenmuster von Modulationssymbolen gemäß Third-Generation-Partnership-Project-Standards (3GPP-Standards) umfasst.

7. Vorrichtung (10) zum Erzeugen von Testsignalen bei verschiedenen Trägerfrequenzen, umfassend:

eine Dateieingabe (11) zum Empfangen einer Liste von Testdateien, umfassend bereits vorhandene Testfrequenzen, die einem Bereich von vordefinierten Tests entsprechen, die durchgeführt werden sollen,
eine Steuereingabe (12) zum Empfangen von Steuerbefehlen, um eine Testdatei aus der Liste von Testdateien auszuwählen,
eine Benutzereingabe (13) zum Empfangen einer Frequenzeingabe von einem Benutzer, und
einen Prozessor (15), der angepasst ist, um die Testdatei zu modifizieren, um die Frequenzeingabe von dem Benutzer anzufordern und um die Frequenzeingabe als eine Testfrequenz anzugeben,
wobei der Prozessor (15) ferner angepasst ist, um einen Satz von Anweisungen in der Testdatei zu erzeugen, um eine Phasenverschiebung für einen Hilfsträgerabstand in Bezug auf die Frequenzeingabe zu berechnen, und

wobei der Prozessor (15) ferner angepasst ist, um ein Phasenmuster von Modulationssymbolen für den Hilfsträgerabstand zu erzeugen, der der Frequenzeingabe entspricht, wodurch ein Testsignal (18) bei der Testfrequenz erzeugt wird.

8. Vorrichtung nach Anspruch 7,
wobei das Testdateiformat ein Lokalisierungsressourcenformat, vorzugsweise ein Anwendungsressourcenbündel-Format (ARB-Format) ist.

9. Vorrichtung nach Anspruch 7 oder 8,
wobei der Prozessor (15) ferner angepasst ist, um Phasenmuster von Modulationssymbolen für jeden Hilfsträgerabstand, der der Frequenzeingabe entspricht, basierend auf den Informationen bezüglich der Berechnung der Phasenverschiebung zu erzeugen, die zuvor in der Testdatei bereitgestellt werden.

10. Vorrichtung nach Anspruch 9,
wobei die Phasenmuster von Modulationssymbolen für jeden Hilfsträgerabstand verschieden sind.

11. Vorrichtung nach Anspruch 9,
wobei der Prozessor (15) ferner angepasst ist, um das jeweilige Phasenmuster von Modulationssymbolen an jedem Hilfsträgerabstand zu implementieren.

12. Vorrichtung nach Anspruch 11,
wobei der Prozessor (15) ferner angepasst ist, um eine Filterung (25) anzuwenden, nachdem das jeweilige Phasenmuster von Modulationssymbolen für jeden Hilfsträgerabstand implementiert wurde.

13. Vorrichtung nach Anspruch 12,
wobei die Filterung (25) auf einer Impulsantwortfilterung, vorzugsweise einer endlichen Impulsantwortfilterung basiert.

14. Vorrichtung nach Anspruch 7,
wobei die Phasenmuster von Modulationssymbolen gemäß den Third-Generation-Partnership-Project-Standards (3GPP-Standards) erzeugt werden.

15. Computerprogramm mit Programmcodemitteln, um mit allen Schritten nach einem der Ansprüche 1 bis 6 fortzufahren, wenn das Computerprogramm auf einem Computer oder einem digitalen Signalprozessor abläuft.

**Revendications**

1. Procédé permettant de générer des signaux de test à différentes fréquences de porteuse qui comprend les étapes de :

sélection d'un fichier de test à partir d'une liste de fichiers de test comprenant des fréquences de test préexistantes correspondant à une plage de tests prédéfinis à effectuer,

modification du fichier de test afin de demander une entrée de fréquence provenant d'un utilisateur et de spécifier l'entrée de fréquence en tant que fréquence de test,

génération d'un ensemble d'instructions dans le fichier de test afin de calculer un déphasage pour un espacement de sous-porteuse par rapport à l'entrée de fréquence, et

génération d'un motif de phase de symboles de modulation pour l'espacement de sous-porteuse correspondant à l'entrée de fréquence générant de ce fait un signal de test à la fréquence de test.

2. Procédé selon la revendication 1,
dans lequel le format du fichier de test est un format de ressource de localisation, de préférence un format Application Resource Bundle (ARB).

3. Procédé selon la revendication 1 ou 2,
le procédé comprenant en outre l'étape de génération de motifs de phase de symboles de modulation pour chaque espacement de sous-porteuse correspondant à l'entrée de fréquence sur la base des informations relatives au calcul du déphasage fourni dans le fichier de test au préalable.

4. Procédé selon la revendication 3,
le procédé comprenant en outre l'étape consistant à mettre en oeuvre le motif de phase respectif de symboles de modulation sur chaque espacement de sous-porteuse.

5. Procédé selon la revendication 4,
le procédé comprenant en outre l'étape consistant à appliquer un filtrage après que le motif de phase respectif de symboles de modulation pour chaque espacement de sous-porteuse a été mis en oeuvre.

6. Procédé selon la revendication 1,
le procédé comprenant en outre l'étape consistant à générer les motifs de phase de symboles de modulation conformément à des normes de projet de partenariat de troisième génération (3GPP).

7. Dispositif (10) permettant de générer des signaux de test à différentes fréquences de porteuse comprenant:

une entrée de fichier (11) permettant de recevoir une liste de fichiers de test comprenant des fréquences de test préexistantes correspondant à une plage de tests prédéfinis à effectuer,
une entrée de commande (12) permettant de recevoir des instructions de commande afin de sélectionner un fichier de test dans la liste de fichiers de test,

une entrée utilisateur (13) permettant de recevoir une entrée de fréquence provenant d'un utilisateur, et

un processeur (15) conçu pour modifier le fichier de test afin de demander l'entrée de fréquence provenant de l'utilisateur et de spécifier l'entrée de fréquence en tant que fréquence de test,

dans lequel le processeur (15) est en outre conçu pour générer un ensemble d'instructions dans le fichier de test afin de calculer un déphasage pour un espacement de sous-porteuse par rapport à l'entrée de fréquence, et

dans lequel le processeur (15) est en outre conçu pour générer un motif de phase de symboles de modulation pour l'espacement de sous-porteuse correspondant à l'entrée de fréquence générant de ce fait un signal de test (18) à la fréquence de test.

8. Dispositif selon la revendication 7,
dans lequel le format du fichier de test est un format de ressource de localisation, de préférence un format Application Resource Bundle (ARB).

9. Dispositif selon la revendication 7 ou 8,
dans lequel le processeur (15) est en outre conçu pour générer des motifs de phase de symboles de modulation pour chaque espacement de sous-porteuse correspondant à l'entrée de fréquence sur la base des informations relatives au calcul du déphasage fourni dans le fichier de test au préalable.

10. Dispositif selon la revendication 9,
dans lequel les motifs de phase de symboles de modulation sont différents pour chaque espacement de sous-porteuse.

11. Dispositif selon la revendication 9,
dans lequel le processeur (15) est en outre conçu pour mettre en oeuvre le motif de phase respectif de symboles de modulation sur chaque espacement de sous-porteuse.

12. Dispositif selon la revendication 11,
dans lequel le processeur (15) est en outre conçu pour appliquer un filtrage (25) après que le motif de phase respectif de symboles de modulation pour chaque espacement de sous-porteuse a été mis en oeuvre.

13. Dispositif selon la revendication 12,
dans lequel le filtrage (25) est basé sur un filtrage à réponse impulsionnelle, de préférence un filtrage à réponse impulsionnelle finie.

**14.** Dispositif selon la revendication 7, dans lequel les motifs de phase de symboles de modulation sont générés conformément aux normes de projet de partenariat de troisième génération (3GPP).

**15.** Programme informatique doté de moyens de code de programme permettant de réaliser toutes les étapes de l'une quelconque des revendications 1 à 6 si le programme informatique s'exécute sur un ordinateur ou un processeur de signal numérique.

```
selecting a test file from a list of test files
corresponding to a range of predefined
tests to be conducted                              100

requesting a frequency input from a user
in order to define a test frequency                101

generating phase patterns of modulation
symbols for each subcarrier spacing
corresponding to the frequency input               102
thereby generating a test signal
at the test frequency
```

Fig. 1

Fig. 2

**Fig. 3**

Fig. 4a

Fig. 4b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10191098 B2
- US 20140233623 A1
- US 20140242919 A1

**Non-patent literature cited in the description**

- **ANRITSU ANRITSU.** IQproducer(TM) Operation Manual. 25 February 2019